(19) **Europäisches Patentamt**

**European Patent Office**

**Office européen des brevets**

(11) Veröffentlichungsnummer : **0 382 879 B1**

(12) **EUROPÄISCHE PATENTSCHRIFT**

(45) Veröffentlichungstag der Patentschrift :
**01.04.92 Patentblatt 92/14**

(21) Anmeldenummer : **89110099.2**

(22) Anmeldetag : **03.06.89**

(51) Int. Cl.⁵ : **G01D 11/28, B60Q 3/04**

(54) **Zeigerinstrument.**

(30) Priorität : **16.02.89 DE 3904657**

(43) Veröffentlichungstag der Anmeldung :
**22.08.90 Patentblatt 90/34**

(45) Bekanntmachung des Hinweises auf die
Patenterteilung :
**01.04.92 Patentblatt 92/14**

(84) Benannte Vertragsstaaten :
**DE ES FR GB IT**

(56) Entgegenhaltungen :
**EP-A- 0 078 372**
**DE-A- 3 139 004**
**US-A- 3 267 598**
**US-A- 4 257 084**

(73) Patentinhaber : **VDO Adolf Schindling AG**
**Gräfstrasse 103**
**W-6000 Frankfurt/Main 90 (DE)**

(72) Erfinder : **Sell, Gerhard**
**Feldstrasse 3**
**W-6231 Schwalbach/Ts. (DE)**

(74) Vertreter : **Klein, Thomas, Dipl.-Ing. (FH)**
**Sodener Strasse 9 Postfach 6140**
**W-6231 Schwalbach a. Ts. (DE)**

## Beschreibung

Die Erfindung betrifft ein Zeigerinstrument mit einem Lichtleiter zum Beleuchten eines Ziffernblattes und mit auf einem Träger angeordneten, elektronischen Bauteilen, insbesondere der Meßwerkelektronik. Solche Zeigerinstrumente sind beispielsweise in heutigen Kraftfahrzeugen vorhanden und deshalb allgemein bekannt.

In den bekannten Zeigerinstrumenten ist als Träger für die elektronischen Bauteile eine Leiterplatte vorgesehen. Dieses Bauteil ist zwischen dem Meßwerk und dem Lichtleiter angeordnet. Da der Platz in der Armaturentafel eines Kraftfahrzeuges knapp ist, besteht ganz allgemein das Erfordernis, die in ihr einzubauenden Zeigerinstrumente und natürlich auch alle anderen Bauteile möglichst kompakt auszubilden.

Aus der Druckschrift US-A-3 267 598 ist ein Instrument mit einer innenbeleuchteten Platte aus einem lichtleitenden Werkstoff bekannt, in die eine Lichtquelle eingebettet ist und auf deren Rückseite die gedruckte Schaltung zur Spannungsversorgung der Lichtquelle angeordnet ist, wobei Platz und Gewicht gespart wird.

Aus der Druckschrift DE-A-3 139 004 ist ferner eine Vorrichtung mit Bedienungsknöpfen bekannt, die während der Zeit, in der sie nicht betätigt sind, in einer anderen Farbe aufleuchten, als in der Zeit, in der sie betätigt sind. Dazu sind in jedem Bedienungsknopf zwei Anzeigelampen unterschiedlicher Farbe vorgesehen, die wechselweise mit Spannung versorgt werden.

Schließlich ist aus der Druckschrift US-A-4 257 084 eine Anzeigevorrichtung mit mehreren Lichtquellen unterschiedlicher Farbe bekannt, die in Abhängigkeit von dem angezeigten Wert mit Spannung beaufschlagt werden und dadurch beim Überschreiten wenigstens einer Schwelle einen Farbumschlag der Anzeige bewirken.

Der Erfindung liegt die Aufgabe zugrunde, ein Zeigerinstrument der eingangs genannten Art so auszubilden, daß es möglichst kompakt baut und möglichst kostengünstig herstellbar ist.

Diese Aufgabe wird erfindungsgemäß dadurch gelöst, daß der Lichtleiter kegelstrumpfförmig ausgebildet ist und mit seiner dem Ziffernblatt abgewandten Außenmantelfläche den Träger für die elektronischen Bauteile bildet.

Durch diese Gestaltung wird der Platz für eine Leiterplatte eingespart. Dadurch kann das Zeigerinstrument flacher ausgebildet werden als die bisherigen Zeigerinstrumente. Zugleich ist es durch das Fehlen eines Bauteils kostengünstiger herzustellen. Ferner wird durch diese Gestaltung der zwischen dem Gehäuse und der die Umlenkschräge bildende Außenmantelfläche ohnehin vorhandene Raum auf geschickte Weise für die elektronischen Bauteile genutzt, so daß das Zeigerinstrument besonders kompakt wird.

Wenn die Zahl der anzuordnenden Bauelemente groß ist und der Platz auf der Außenmantelfläche nicht reicht, dann ist es vorteilhaft, wenn auf der dem Ziffernblatt abgewandten Kreisgrundfläche des Kegelstumpfförmigen Lichtleiters flache, elektronische Bauteile und auf der Außenmantelfläche die übrigen Bauteile angeordnet sind.

Die elektrische Verbindung der elektronischen Bauteile kann auf gleiche Weise wie bei Leiterplatten erfolgen, wenn die Leiterbahnen der elektronischen Bauteile ebenfalls auf dem Lichtleiter vorgesehen sind.

Die Erfindung läßt zahlreiche Ausführungsformen zu. Zur weiteren Verdeutlichung ihres Grundprinzips ist eine davon in der Zeichnung dargestellt und wird nachfolgend beschrieben. Diese zeigt in

Fig. 1 ein erfindungsgemäß gestaltetes Zeigerinstrument in Explosionsdarstellung, ohne Gehäuse,

Fig. 2 eine Ansicht von unten auf den Lichtleiter des Anzeigeinstrumentes,

Fig. 3 einen horizontalen Schnitt durch den Lichtleiter.

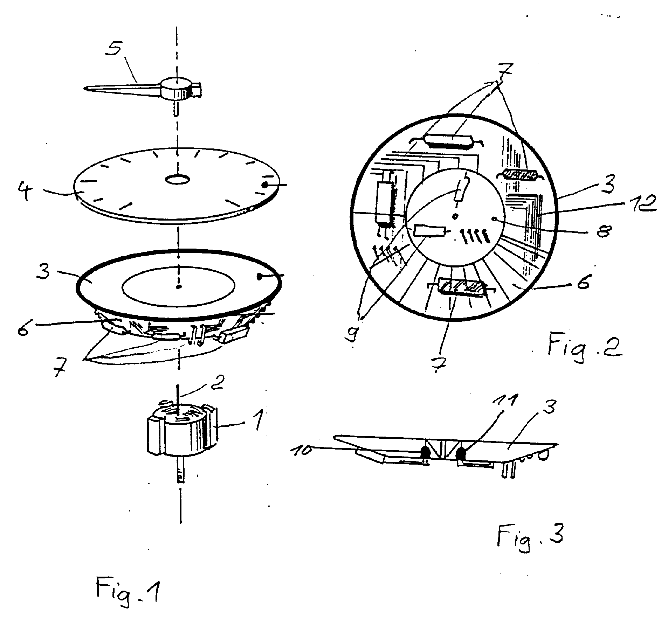

Die Figur 1 zeigt ein Meßwerk 1, bei dem es sich beispielsweise um ein Drehmagnet-Quotientenmeßwerk handelt. Das Meßwerk 1 hat eine Meßwerkwelle 2, welche im montierten Zustand des Zeigerinstrumentes einen kegelscheibenförmigen Lichtleiter 3 und ein Ziffernblatt 4 durchdringt, so daß auf sie ein Zeiger 5 montiert werden kann.

Der Lichtleiter 3 hat aufgrund seiner kegelscheibenförmigen Ausbildung eine kegelig verlaufende Außenmantelfläche 6, auf der elektronische Bauelemente 7 angeordnet sind. Es handelt sich hierbei um die Meßwerkelektronik und beispielsweise um Bauelemente zur Ansteuerung einer Instrumentenbeleuchtung oder von im Instrument angebrachten Warnlampen. Nicht dargestellt sind in Figur 1 die Leiterbahnen der Bauelemente 7, welche ebenfalls auf dem Lichtleiter 3 vorgesehen sind und beispielsweise durch Beschichtung aufgebracht sein können.

Die Figur 2 zeigt den Lichtleiter 3 mit den elektronischen Bauteilen 7 von unten. Dargestellt ist in dieser Figur 2 weiterhin, daß auch auf der Kreisfläche 8 des Lichtleiters 3 elektronische Bauteile 9 angeordnet werden können. Um die Baugröße des Zeigerinstrumentes jedoch möglichst klein halten zu können, wird man dort vorzugsweise flache Bauteile 9 und die höheren Bauteile 8 auf der Außenmantelfläche 6 anordnen. In ,Figur 2 sind desweiteren auf dem Lichtleiter 3 vorgesehene Leiterbahnen 12 dargestellt.

In der Figur 3 ist zu sehen, daß im Lichtleiter 3 zwei Leuchtdioden 10, 11 angeordnet sein können.

**Patentansprüche**

1. Zeigerinstrument mit einem Lichtleiter (3) zum Beleuchten eines Ziffernblattes (4) und mit auf einem Träger angeordneten elektronischen Bauteilen (7, 9), insbesondere der Meßwerkelektronik, dadurch gekennzeichnet, daß der Lichtleiter (3) kegelstumpfförmig ausgebildet ist und mit seiner dem Ziffernblatt (4) abgewandten Außenmantelfläche (6) den Träger für die elektronischen Bauteile (7) bildet.

2. Zeigerinstrument nach Anspruch 1, dadurch gekennzeichnet, daß auf der dem Ziffernblatt (4) abgewandten Kreisgrundfläche (8) des kegelstumpfförmigen Lichtleiters (3) flache elektronische Bauteile (9) und auf der Außenmantelfläche die übrigen Bauteile (7) angeordnet sind.

**Claims**

1. Pointer instrument with a light guide (3) for illuminating a dial (4) and with electronic components 17, 9), particularly the electronic measurement systems, arranged on a mount, characterised in that the light guide (3) has the shape of a truncated cone and its outer casing surface (6) remote from the dial (4) forms the mount for the electronic components (7).

2. Pointer instrument according to claim 1, characterised by arranging flat electronic components (9) on the circular base surface (8), remote from the dial (4), of the truncated cone-shaped light guide (3), and by arranging the remaining components (7) on the outer casing surface.

**Revendications**

1. Instrument indicateur à aiguille comportant un conducteur (3) de lumière destiné à éclairer un cadran (4) et des composants électroniques (7, 9),notamment ceux de l'équipement de mesure électronique, disposés sur un support, instrument caractérisé en ce que le conducteur (3) de lumière a une forme tronconique et sa surface latérale extérieure (6), orientée dans le sens opposé au cadran (4), constitue le support des composants électroniques (7,).

2. Indicateur à aiguille selon la revendication 1, caractérisé en ce que des composants électroniques (9) plats sont disposés sur la surface de base (8), circulaire, opposée au cadran (4),du conducteur tronconique (3) de lumière, et les autres éléments (7) sont disposés sur la surface latérale extérieure.

Fig.1

Fig.2

Fig.3